(19) **Europäisches Patentamt**
**European Patent Office**
**Office européen des brevets**

(11) **EP 2 162 752 B1**

(12) **EUROPEAN PATENT SPECIFICATION**

(45) Date of publication and mention
of the grant of the patent:
**13.11.2019 Bulletin 2019/46**

(21) Application number: **08763463.0**

(22) Date of filing: **03.07.2008**

(51) Int Cl.:
*H01M 10/44* (2006.01)     *G01R 31/36* (2019.01)

(86) International application number:
**PCT/IB2008/052676**

(87) International publication number:
**WO 2009/007885 (15.01.2009 Gazette 2009/03)**

(54) **METHOD AND DEVICE FOR DETERMINING THE STATE OF CHARGE OF A BATTERY**

VERFAHREN UND EINRICHTUNG ZUR BESTIMMUNG DES LADUNGSZUSTANDS EINER
BATTERIE

PROCÉDÉ ET DISPOSITIF POUR DÉTERMINER L'ÉTAT DE CHARGE D'UNE BATTERIE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **09.07.2007 EP 07112025
31.08.2007 EP 07115454**

(43) Date of publication of application:
**17.03.2010 Bulletin 2010/11**

(73) Proprietor: **Koninklijke Philips N.V.
5656 AE Eindhoven (NL)**

(72) Inventors:
• **MARTENS, Hubert, C., F.
5656 AE Eindhoven (NL)**
• **NOTTEN, Petrus, H., L.
5656 AE Eindhoven (NL)**

(74) Representative: **Kroeze, Johannes Antonius
Philips Intellectual Property & Standards
High Tech Campus 5
5656 AE Eindhoven (NL)**

(56) References cited:
**WO-A1-00/69012          US-A- 5 717 256
US-A1- 2002 167 293     US-A1- 2005 102 005
US-B1- 7 295 878**

**Description**

FIELD OF THE INVENTION

The invention relates to the field of methods and devices for determining the state of charge of a battery. In particular the invention relates to a method and a device for determining the state of charge of a battery used for powering a medical device implanted into a human or animal body.

BACKGROUND OF THE INVENTION

US 6,901,293 B2 discloses a power source longevity monitor for an implantable medical device. An energy counter counts the amount of energy used by the implantable medical device. An energy converter converts the energy used into an estimate of remaining power source longevity and generates an energy longevity estimate. A voltage monitor monitors the voltage of the power source. A voltage converter converts the voltage monitored by the voltage monitor into an estimate of remaining longevity of the power source and generating a voltage longevity estimate. A calculator is operatively coupled to the energy converter and to the voltage converter and predicts the power source longevity using the energy longevity estimate early in the useful life of the power source and using the voltage longevity estimate later in the useful life of the power source. The functionality of the device disclosed in US 6,901,293 B2 is based on an operative coupling between the power source longevity monitor and the power source and therapeutic delivery device, respectively. The prediction of the remaining power source longevity relies on measurements of the implant's energy consumption as wells as the battery voltage during discharge of the battery.

US 5,717,256 discloses a power supply apparatus including a battery, voltage converter for converting the output of the battery to a different D.C. voltage by ON/Off action of a main voltage converter control switch circuit, and a device for estimating a remaining capacity of the battery. With the remaining battery capacity estimation device detects a non-load voltage of the battery when the main voltage converter control switch circuit is OFF, and estimates the remaining capacity of the battery.

WO 00/69012 discloses an implantable power management system which performs monitoring of the current drawn by the implant to predict battery life.

SUMMARY OF THE INVENTION

It would be advantageous to provide a method and a device for determining the state of charge of a battery which requires little action by the user of the battery. It would also be desirable to keep the complexity of the battery itself or the system powered by the battery, which is possibly implanted into the patient's body, low.

The invention is defined by the claims.

To better address one or more of these concerns, in a first aspect of the invention a method for determining the state of charge (SoC) of a battery is provided comprising the steps: charging the battery, discharging of the battery, predicting the state of charge of the battery using a recharge prediction unit, wherein the recharge prediction unit is disconnected from the battery during the discharging of the battery, and comprising the additional steps: connecting the recharge prediction unit to the battery before charging, charging the battery, measuring battery parameters during the charging of the battery, disconnecting the recharge prediction unit from the battery before discharging the battery, predicting the state of charge of the battery using the battery parameters measured during charging of the battery. The prediction of the state of charge of the battery during the discharge of the battery, i.e. during powering of a device connected to the battery, without carrying out any measurements during the discharging of the battery, enables a local separation of the battery or the device powered by the battery, i.e. a medical implant, and the recharge prediction unit (RPU) during the discharge cycle of the battery.

In terms of the present application "disconnected" shall mean that no connection, including wired or wireless communication, for providing energy or signal transmission between the RPU and the battery is established.

Although in an embodiment of the present invention the battery and the RPU shall be disconnected during the entire discharging of the battery, there may be alternative embodiments, in which the battery and the RPU may remain connected shortly after charging or shortly before charging the battery. For example when charging a medical implant one could leave the battery and the RPU connected for a certain period of time after the charging has been completed and discharging of the battery commences. If compared to the overall run-time of the freshly charged battery keeping the connection between the battery and the RPU upright shortly after charging still implies that the battery and the RPU are disconnected during almost the complete discharging process.

In an embodiment of the present invention the state of charge of the battery and therefore the remaining run-time of the battery until a recharge would be necessary, is calculated based on an accurate model of the discharging process that is based on battery status and drainage characteristic of the device powered by the battery, i.e. the device's power consumption. In a further embodiment the model takes into account the aging of the rechargeable battery for which the remaining run-time shall be predicted. This helps to consider effects due to a battery changing its capacity over its overall life time.

In an embodiment of the present invention the model used for predicting the state of charge of the battery may be based on an assumption of the amount of charge available from the battery directly after recharging. This overall amount of charge available from the battery could either be measured as laid out in detail below or based on a model without measurements assuming the general behavior of the battery.

In a further embodiment of the present invention the step of predicting the state of charge of the battery is carried out using a parameter indicating a period of time having elapsed since recharging of a battery was finished. This consideration of the time having elapsed since recharging allows an exact prediction of the state of charge of the battery, i.e. the remaining run time of the battery during the current discharge cycle.

An embodiment of the present invention is desirable in which the step of predicting the state of charge of the battery is carried out by using the following parameters alternatively or in any combination thereof: A parameter indicating a characteristic of the battery, e.g. its capacity, its nominal current or its nominal voltage, a parameter indicating environmental parameter of the battery and/or the device powered, e.g. temperature, a parameter indicating the power consumption of the device powered by the battery, the number of operating cycles of the device power, etc.

In an embodiment of the invention the step of predicting the state of charge of the battery is carried out modeling the aging of the battery. In terms of the present application a measurement "during the charging of the battery" means includes intervals directly prior and directly after charging.

Further to the previously described embodiments this embodiment helps to predict the state of charge of the battery during the discharge cycle more accurately due to the incorporation of parameters measured during the charging cycle of the battery. During the charging of the battery the battery must be connected to a battery charger in order to deliver energy to the battery. Therefore during the charging cycle the battery and thus the device connected to the battery must be brought into contact with the charging device in any case. Thus the requirement to bring the recharge prediction unit into contact with the battery does not add any further inconvenience or complexity to the usage of the system comprising the battery, the device powered by the battery, the battery charger and the recharge prediction unit.

However, a measurement of battery parameters during the charging of a battery allows to accurately determine the state of charge at the end of the charging cycle, i.e. determining the overall amount of charge available from the battery after recharging and furthermore allows to take into account aging effects of the battery not only by modeling, but by detecting the actual state of the battery with respect to its overall lifetime.

An example of an embodiment of the present invention providing a model for determining the state of charge of a battery is given in the following description. The state of charge and the maximum charge available from a battery are updated during recharging of the battery. To achieve this the following steps are carried out: The state of charge prior to charging is measured, the amount of charge flowing into the battery during the charging cycle is determined, the state of charge is measured after the charging cycle has successfully been completed.

The state of charge prior to charging can be obtained by measuring the battery voltage when the battery is in a relaxed or stand-by state, operating at very low or no drain currents, i.e. the so called equilibrium voltage value (EMF). From the EMF the state of charge may be calculated using a look-up table. However the battery drain in many practical applications, e.g. medical devices, is so low that in practice the battery operates very near its stand-by-state, so a measured battery voltage directly yields EMF. Thus in embodiments of the present invention EMF and thus $SoC_{si}$ can be determined directly prior to onset of charging process without any entire relaxation of the battery.

In an embodiment the state of charge $SoC_{si}$ before the beginning of a recharging of the battery is determined.

The amount of charge $Q_{ch}$ flowing into the battery during the charging period is simply obtained by integrating the charging current flowing into the battery during the charging period.

In an embodiment of the present invention the EMF is measured again after charging has been completed. This measurement could be carried out after a "transitional" period in which battery overpotential (due to battery charging) relaxes. From this measured EMF the state of charge $SoC_{sf}$ after charging is estimated. The overall maximum charge capacity $Q_{max}$ available from the battery after charging could then be calculated from the following equation:

$$Q_{max} = \frac{100}{SoC_{sf} - SoC_{si}} Q_{ch}$$

This approach corrects for battery aging and takes into account remaining battery capacity prior to the charging. The charge available for operation of the device $Q_{av}$ is calculated from

$$Q_{av} = Q_{max} * SoC_{sf}.$$

In an embodiment of the present invention the battery is recharged while the device powered by the battery is still operated. Under these circumstances it could be the case that the battery discharge rate during charging is too high to allow a direct determination of the EMF of the battery. Then the method for recharging the battery will be started by replacing the battery as the power source by an external recharger delivering the power needed to operate the device which had previously been powered by the battery. The battery is then put on stand-by while the external power source, i.e. the recharger, continuous to power the device. The battery voltage then relaxes to the EMF. The EMF and thus the state of charge of the battery can then be determined either from the dynamics of relaxation into the relaxed state of the battery or by the end value of the EMF. After relaxation of the battery into the stand-by mode charging of the battery is started as described above.

In an embodiment of the present invention after charging the battery may be put into stand-by again before determining the EMF. The final state of charge of the battery is then determined before the device is once again powered by the freshly recharged battery.

In an embodiment the battery voltage and charging current are measured during charging. From the relation between battery voltage and charging current $Q_{max}$ is derived using a mathematical model of the battery.

In an embodiment the battery charging is interrupted one or more times to let the battery voltage relax to EMF leading to an intermediate SoC estimate during the charging. By combining the one or more intermediate measurements of the integrated charging current and SoC and the final measurements, more accurate estimates of $Q_{max}$ using the methodology described above can be obtained.

In an embodiment of the invention the state of charge determined during the measurements is compared to a corresponding model value and the model for the battery is adaptively updated to the battery used.

In an embodiment of the present invention the SoC values, $Q_{max}$ values and recharge time stamps from one or more, or at least the last, recharging sessions are stored. This storage in an embodiment occurs in the battery or a device associated with the battery, such that the storage is disconnected from the RPU during discharging of the battery.

In an embodiment the measured $SoC_{si}$ from the current charging session and the stored $SoC_{sf}$ and $Q_{max}$ from the previous charging session and the elapsed time between the charging events are used to estimate the average battery drain $I_{drain}$.

In a further embodiment the voltage of the battery $V_{bat}$ is measured at the onset of the discharging of the battery. Then the difference between $V_{bat}$ and the EMF after charging is determined. This difference is referred to as the overpotential. Typically $V_{bat}$ will be lower than the EMF. The overpotential is influenced e.g. by the ageing of the battery or by temperature. Thus the overpotential may help to determine the amount of charge that can be withdrawn from the battery under predetermined conditions. The charge that can be withdrawn from the battery is distinct from the available charge in the battery. According to an empirical relationship the State-of-Charge left $SoC_l$ can be calculated at a given C-rate discharge current ($C$), from the following equation

$$SoC_l = \frac{\left[ C \left( \frac{SoC_{st}}{100} \right)^{\varsigma(\vartheta-C)} \right]^{\gamma+\delta T}}{\alpha + \beta T}$$

where $SoC_{st}$ in % denotes the SoC at the beginning of the discharge at C-rate current $C$ and temperature $T$ in °C. $\varsigma, \vartheta, \gamma, \delta, \alpha, \beta$ are parameters determined empirically by the fitting of experimentally measured $SoC_l$ data. When the $SoC_l$ function described by the above equation is substituted in the following relation

$$t_r [\min] = \frac{0.06 \frac{Q_{max}}{100} (SoC_d - SoC_l)}{I_d}$$

wherein $SoC_d$ and $I_d$ are the state-of-charge and the current immediately after discharging has started, respectively, the remaining run-time $t_r$ at any point in time can be accurately predicted, immediately after discharging has started. The overall maximum charge capacity $Q_{max}$ available from the battery after charging may be calculated as stated above from the following equation:

$$Q_{max} = \frac{100}{SoC_{sf} - SoC_{si}} Q_{ch} ,$$

wherein $SoC_{si}$ and $SoC_{sf}$ are the state of charge before the beginning of a recharging of the battery and after charging, respectively. $Q_{ch}$ is the amount of charge flowing into the battery during the charging period, which can be obtained by integrating the charging current flowing into the battery during the charging period. This way the prediction of the remaining run-time $t_r$ according to an embodiment accounts for the overpotential after recharging of the battery and thus for the ageing of the battery.

In an embodiment of the method according to the present invention the average battery drain is adaptively calculated using stored values from at least one previous charging session. Calculation of the average battery drain is carried in the RPU.

In an embodiment the device powered by the rechargeable battery or a device associated with the battery contains means to measure average battery drain and means to transmit this information to the RPU.

The autonomy time $T_a$ of the device powered by the rechargeable battery may be calculated from the available charge in the device, the battery drain, and a critical state of charge level $SoC_{min}$ where recharging becomes desirable:

$$T_a = Q_{max}(SoC_{sf} - SoC_{min})/I_{drain}$$

The remaining run-time is calculated as the difference between the autonomy time and the time elapsed since the last recharge.

The remaining run-time may be displayed to the user and a warning signal may be given out alternatively or in addition to the remaining run-time when the remaining run-time drops below a critical pre-stored value.

In an embodiment the method according to the present invention may be used in order to provide an indication for the state of charge of a battery used to power a medical implant and thus to determine the remaining run-time of that battery. Batteries in medical implants do have the advantage of being operated at well known conditions, i.e. at constant temperature and constant and reproducible power consumption such that drainage of the battery during the discharge operation can be very accurately modeled.

To better address one or more of the above concerns, in a further aspect of the invention a recharge prediction unit is provided, comprising a processor, and a connecting device, wherein the processor is arranged for predicting of the state of charge of a battery during the discharging of the battery while the recharge prediction unit being disconnected from the battery, and wherein the connecting device is arranged to establish a connection between the recharge prediction unit and the battery, and wherein the recharge prediction unit is arranged to enable a prediction of the state of charge of a battery according to the above method.

In an embodiment the connecting device may be a male or female connector. However, a connecting device in terms of the invention could also be any other means for the transfer of energy or information such as a radio frequency receiver/transmitter or an inductive coupling.

In a further embodiment the recharge prediction unit may comprise a memory for storing at least one parameter for the prediction of the state of charge of the battery. The at least one parameter may in an embodiment be one of the parameters used for the prediction of the state of charge as discussed above.

The recharge prediction unit according to an embodiment of the invention may comprise an up-dating device for up-dating the at least one parameter. The updating device updates the parameter when the connecting device is connected to the battery or any device associated with the battery during charging of the battery. The updated parameter may be stored in the memory. The updated parameters are parameters determined during the charging of the device. In other examples outside the scope of the invention the parameters could also be parameters which have been obtained and stored by the battery or any associated device during discharging, which are only communicated to the recharge prediction unit during the charging operation.

A recharge prediction unit enabling a prediction of the state of charge of a battery using the method according to an embodiment of the present invention may be integrated in a battery charger. Alternatively the recharge prediction unit may be a unit being separate from the battery as well as from the battery charger.

In a further embodiment it may be the implantable device itself which comprises a recharge prediction unit according to an embodiment of the present invention. However, the recharge prediction unit according to an embodiment of the present invention may alternatively be integrated into the battery itself.

These and other aspects of the invention will be apparent from and elucidated with reference to the embodiments described hereinafter.

BRIEF DESCRIPTION OF EMBODIMENTS

Fig. 1 diagrammatically shows the components of a recharge prediction unit according to an embodiment of the present invention.

Fig. 2 schematically shows a method performed by a recharge prediction unit according to an embodiment of the present invention to estimate the remaining run-time of a battery.

Fig. 3 shows a rechargeable implanted medical device with a recharge prediction unit according to an embodiment of the present invention.

Fig. 4 schematically shows a smoke detector with a separate recharge prediction unit according to an embodiment of the present invention.

Fig. 5 schematically shows an alarm clock in combination with a separate recharge prediction unit according to an embodiment of the present invention.

Fig. 6 is a flow chart schematically illustrating a process according to an embodiment of the invention for estimating the energy content of a battery.

Fig. 7 is a flow chart schematically illustrating another process for estimating the remaining run-time of a battery.

DETAILED DESCRIPTION OF EMBODIMENTS

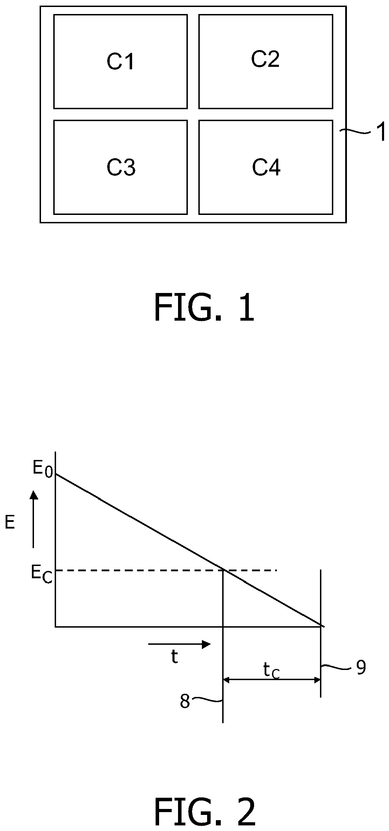

Fig. 1 schematically shows the components of a recharge prediction unit 1 according to an embodiment of the present invention. It comprises four elements C1 - C4:

Denoted by C1 (Initial energy content estimator) is the initial energy content estimator. Element C1 estimates the content of energy of the electrical source of energy, i.e. a battery, before usage of a device being powered by the rechargeable energy source after a recharge operation occurred. This estimation of the energy content of the electrical energy source requires the prediction of the overall charge available from the energy source.

The initial energy content estimator may either be based on an accurate modeling of the rechargeable energy source or additionally on measurements taken during the recharging process of the energy source.

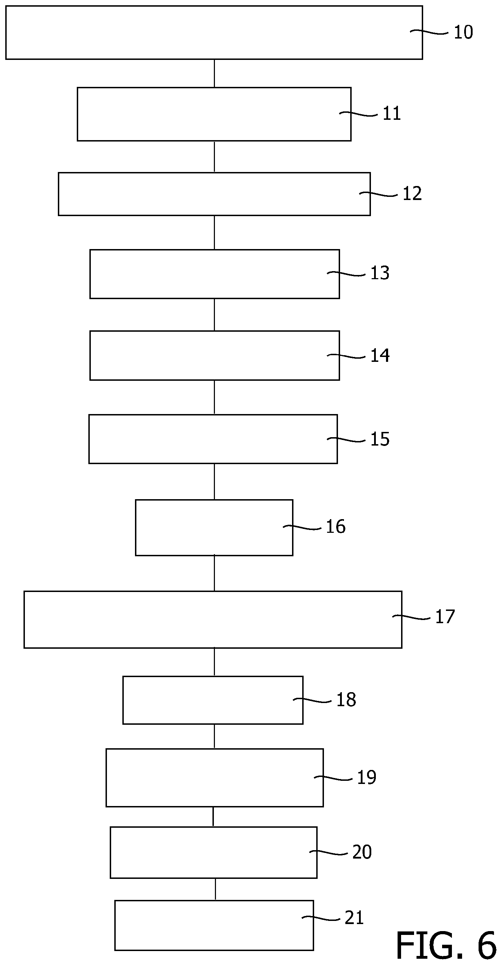

In an embodiment C1 estimates the content of the energy source by the process described now with reference to fig. 6. When in step 10 (RPU: Battery needs to be recharged) the recharge prediction unit (RPU) 1 determines that the battery needs to be recharged, the operator, e. g. a patient having an electrically powered implant or a medical doctor, connects the recharger to the battery in step 11 (Connect recharger/RPU to battery). In the described embodiment, the recharger as well as the recharge prediction unit, are integrated into a single device. In step 12 (Recharger takes over energy delivery) the recharger being connected to the battery and thus to the device being powered by the battery takes over energy delivery to the powered device such that the battery in step 13 (Battery relaxation) relaxes into a standby mode showing any or a very low battery discharge current. After the battery has relaxed, the battery voltage (EMF) of the relaxed battery is measured in step 14 (RPU: Measure EMF). However, in an alternative embodiment a relaxation of the battery can be omitted if the battery drain during operation is very small such that the battery is in a quasi relaxed state such that the measured voltage is a good approximation of the EMF. The measured EMF is used to determine the state of charge $SoC_{si}$, i.e. a percentage of the maximum charge available from the battery in the fully charged condition, from a look-up table in step 15 (RPU: Determine $SoC_{si}$). The battery is then in step 16 (Charge battery) recharged by the recharger. In step 17 (RPU: Determine amount of charge $Q_{ch}$) the overall amount of charge $Q_{ch}$ going into the battery during the charging period is determined by integrating the charging current into the battery during the charging period. After charging has been completed, the EMF is measured again in step 18 (RPU: Measure EMF) for the charged state of the battery and thus the state of charge $SoC_{sf}$ is determined from the look-up table in step 19 (RPU: Determine $SoC_{sf}$). In step 20 (RPU: Calculate $Q_{max}$) the overall maximum charge capacity $Q_{max}$ being available from the battery after recharging is then calculated from the following equation:

$$Q_{max} = \frac{100}{SoC_{sf} - SoC_{si}} Q_{ch}.$$

The charge available for powering the device is given by $Q_{max}*SoC_{sf}$. The discharger and RPU, respectively, are then disconnected from the battery in step 21 (Disconnect charger/RPU).

Referring to fig. 1 component C2 (Energy drain estimator) then takes over operation of the recharge prediction unit in order to determine the actual state of charge of the freshly recharged battery during energy drain of the battery. C2 therefore takes into account the environmental parameters of the battery and the device powered, e.g. temperature, as well as the energy consumption of the device powered by the battery. As the RPU which is connected to the recharger determines when the recharging process is finished and thus the battery once again takes over powering of the device from the recharger, the recharge prediction unit can determine the time having elapsed since recharging of the battery was completed

From the initial energy content estimated by C1 as well as the energy estimated to have drained from the battery during the discharge operation by C2, component C3 (Remaining time estimator) calculates the remaining run-time of the battery. This remaining run-time is indicated by component C4 (Recharge indication to user) to the user in terms of a display indicating the remaining run-time in days, hours and minutes. Component C4 furthermore activates a warning signal in case the state of charge of the battery has reached a critical level, in the example shown 20% of the initial state of charge, indicating the user to recharge the battery. This may be performed in a graded manner, i.e. increasing warnings are issued when the state of charge becomes more and more critical.

In the example described in detail above the battery is a Li-ion (liquid or polymer) battery. However, similar solutions could be achieved when using other rechargeable power sources/batteries, e.g. all-solid-state batteries.

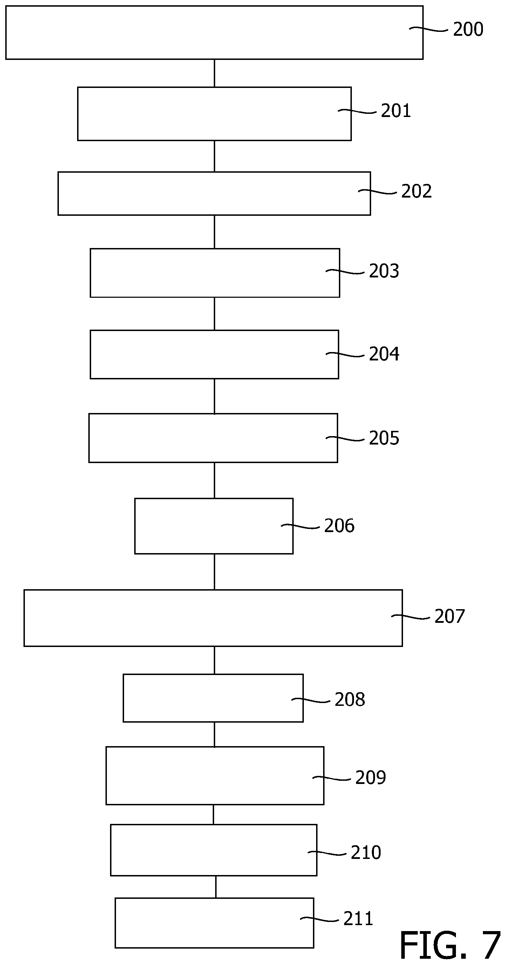

In fig. 2 the estimated energy level E available from the battery versus time t is exemplarily shown. When the overall energy level available from the battery drops below a critical energy level Ec at a given time 8 the user of a battery powered device is informed by the recharge prediction unit that a recharge of the battery is needed. This occurs well before the end of operation 9. An alternative method for determining the state of charge and thus the remaining run-time of a battery is depicted schematically in fig. 7 in the form of a flow chart. This example does not form part of the invention but provides further insight useful for understanding the invention. It takes into account the so-called overpotential, defined as the difference between the EMF immediately after charging and the voltage of the battery directly at the onset of the discharging of the battery. The overpotential is strongly influenced by the ageing of the battery. Thus taking into account the overpotential allows for the consideration of the ageing of the battery when determining the remaining run-time $t_r$ of the battery.

The method according to this example relies on an empirical relationship between actual the state of charge left $SoC_l$ in a battery and the state-of-charge at the beginning of the discharge $SoC_{st}$:

$$SoC_l = \frac{\left[ C\left(\dfrac{SoC_{st}}{100}\right)^{\varsigma(\vartheta - C)} \right]^{\gamma + \delta T}}{\alpha + \beta T},$$

wherein $T$ is the actual constant temperature in °C and $C$ is the C-rate discharge current. Therefore before using the method in order to determine the remaining run-time of a battery employed in a real world application, the typical behavior of the respective battery must be measured experimentally for a given temperature $T$ and a C-rate discharge current $C$ in order to determine the five parameters $\varsigma,\ \vartheta,\ \gamma,\ \delta,\ \alpha,\ \beta$.

Thus, in step 200 (Determine $SoC_l$ vs. $SoC_{st}$) in fig. 7 the state-of-charge left $SoC_l$ in a specific battery is determined from EMF measurement as stated above for different states of charge at the beginning of the discharge $SoCst$. For those measurements the temperature $T$ as well as the discharge current $C$ are chosen such that they resemble the conditions under which the battery will be employed, e.g. for powering an implant at 37 °C and at a constant current of 50 mV. In step 201 (Fit empirical formula to measured curve) the curve from the measurement is fitted by the above relationship followed by the extraction of the five parameters $\varsigma,\ \vartheta,\ \gamma,\ \delta,\ \alpha,\ \beta$ in step 202 (Obtain parameters $\varsigma,\ \vartheta,\ \gamma,\ \delta,\ \alpha,\ \beta$). After step 202 has successfully been completed the obtained empirical relationship can be employed in order to determine the remaining run-time $t_r$ for the same battery device under operational conditions.

In step 203 (Determine state of charge of battery before recharging) the stage-of-charge $SoC_{si}$ of the battery is determined before the beginning of a recharging of the battery in step 204 (Charging of the battery). During the recharging the amount of charge flowing into the battery is determined in step 205 (Determine $Q_{ch}$) by integrating the charging current $Q_{ch}$ flowing into the battery over the complete charging period. After recharging has being completed the state-of-charge $SoC_{sf}$ is determined in step 206 (Determine $SoC_{sf}$). From the three parameters $SoC_{si}$, $SoC_{sf}$ and $Q_{ch}$ determined during charging the maximum charge capacity $Q_{max}$ available from the battery of is calculated in step 207 (Calculate $Q_{max}$) from

$$Q_{max} = \frac{100}{SoC_{sf} - SoC_{si}} Q_{ch}.$$

In step 208 (Determine $SoC_{st}$) the state-of-charge $SoC_{st}$ of the battery at the beginning of a discharge process with a current $C$ and at environmental temperature $T$ is determined as described above. The value for $SoC_{st}$ in % derived from measurement is then used to calculate the state-of-charge left $SoC_l$ according to the above relationship in step 209 (Calculate $SoC_l$). When discharging of the battery at constant current C has started the state of charge $SoC_d$ as well as the discharge current $I_d$ are immediately measured in step 210 (Determine $SoC_d$ and $I_d$).

Having now obtained all necessary parameters $Q_{max}$, $SoC_d$, $SoC_l$ and $I_d$ the remaining run-time $t_r$ in minutes can be calculated in step 211 (Calculate $t_r$) from the below expression

$$t_r[\min] = \frac{0.06 \dfrac{Q_{max}}{100}\left(SoC_d - SoC_l\right)}{I_d}.$$

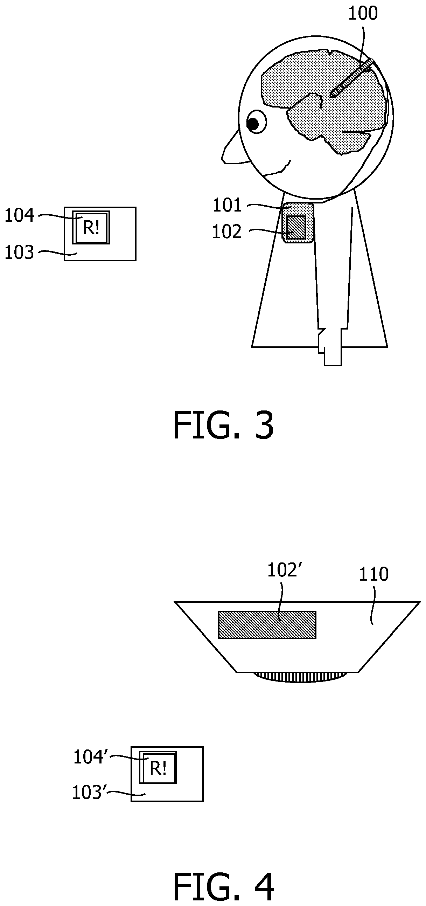

Figures 3 to 5 show applications of the method as well as the recharge prediction unit for determining the state of charge of a battery according to embodiments of the present invention. An envisaged application is shown in fig. 3. This example relates to a rechargeable deep brain stimulation device 100. The device is programmed to a particular stimulation program by means of a programming unit 101 which is powered by a rechargeable battery 102. The devices are charged by a charger 103. The energy content of a battery is measured by a power management unit in the device and is communicated to the charger 103. The power management unit corresponding to component C1 in fig. 1 in the example shown is integrated into the program unit 101 while the other components are part of the recharge prediction unit 104 itself. Upon termination of the charging the charger 103 communicates the updated energy content to the recharge prediction unit 104. Based on the state of charge of the battery 102 after recharging and the parameters of the stimulation program, i.e. the energy consumption of the device 100, the recharge prediction unit in the following estimates the curve for the battery drainage. The recharge prediction unit 104 resets an internal clock and tracks the time elapsed after recharging has been finished. When the estimated energy level or estimated remaining run-time drops below a critical value (e. g. set by a physician or pre-programmed in the device), the recharge prediction unit provides a message to the user on a display, which might be a computer display or a television set, suggesting the user to recharge the device. The user may be a patient, a physician or a relative of the patient.

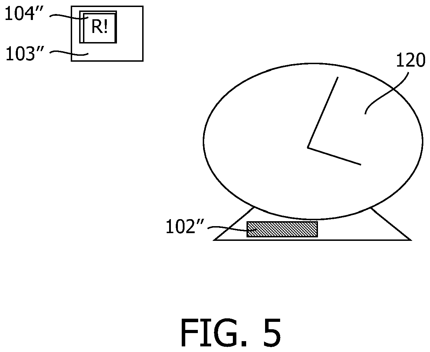

Further applications are shown in figures 4 and 5, wherein equal parts have been assigned equal reference numbers.

Fig. 4 shows a smoke detector 110 running on a rechargeable battery 102. A physical separate recharge indicator 104 integrated into a recharger 103 predicts the remaining operation time and informs a user when the detector's battery needs to be recharged.

Fig. 5 shows an alarm clock 120 being powered by a rechargeable battery 102. A physical separate recharge indicator 104 integrated into a recharge unit 103 predicts the remaining run-time and informs a user when the clock's battery needs to be recharged.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practising the claimed invention, from a study of the drawings, the disclosure and the appended claims. In the claims, the word "comprising" does not exclude other elements or steps, and the indefinite article "a" or "an" does not exclude a plurality. The fact that certain measures are recited in mutually different dependent claims does not indicate that the combination of these measures cannot be used to advantage. Any reference signs and the claims should not be construed as limiting the scope.

LIST OF REFERENCE NUMBERS:

| 1 | recharge prediction unit |
|---|---|
| C1 - C4 | essential elements |
| 10 | RPU: Battery needs to be recharged |
| 11 | connect recharger/RPU to battery |
| 12 | recharger takes over energy delivery |
| 13 | battery relaxation |
| 14 | RPU: Measure EMF |
| 15 | RPU: Determine $SoC_{Si}$ |
| 16 | charge battery |
| 17 | RPU: Determine amount of charge $Q_{ch}$ |
| 18 | RPU: Measure EMF |
| 19 | RPU: Determine $SoC_{sf}$ |
| 20 | RPU: Calculate $Q_{max}$ |
| 21 | disconnect charger/RPU |
| 100 | stimulation device |
| 101 | programming unit |
| 102 | rechargeable battery |
| 103 | charger |
| 104 | prediction unit |
| 110 | smoke detector |
| 120 | alarm clock |
| 200 | determine $SaC_l$ vs. $SoC_s$ |
| 201 | fit empirical formula to measured curve |
| 202 | obtain fitting parameters $\varsigma, \vartheta, \gamma, \delta, \alpha, \beta$ |
| 203 | determine state of charge of battery before recharging |
| 204 | charging of the battery |
| 205 | determine $Q_{ch}$ |
| 206 | determine $SoC_{sf}$ |
| 207 | calculate $Q_{max}$ |
| 208 | determine $SoC_{st}$ |
| 209 | calculate $SoC_l$ |
| 210 | determine $SoC_d$ and $I_d$ |
| 211 | calculate remaining run-time $t_r$ |

**Claims**

1. Method for determining the state of charge of a battery (102) comprising the steps:

   connecting (11) a recharge prediction unit to the battery before charging the battery,
   charging (16, 204) the battery,
   measuring (14, 18) battery parameters during the charging of the battery,
   disconnecting (21) the recharge prediction unit from the battery before discharging the battery,
   discharging the battery,
   predicting (15) the state of charge of the battery using the recharge prediction unit and using the battery parameters measured during charging (16, 204) of the battery, the prediction being without carrying out any measurements during the discharging of the battery,
   wherein the recharge prediction unit is disconnected from the battery during the discharging of the battery.

2. Method according to claim 1, wherein the step of predicting (15) the state of charge of the battery is carried out using a parameter indicating a period of time having elapsed since recharging of the battery was finished.

3. Method according to claim 1, wherein the step of predicting (15) the state of charge of the battery is carried out using a parameter indicating a characteristic of the battery.

4. Method according to claim 1, wherein the step of predicting (15) the state of charge of the battery is carried out using a parameter indicating an environmental parameter of the battery.

5. Method according to claim 1, wherein the step of predicting (15) the state of charge of the battery is carried out modeling the ageing of the battery.

6. Method according to claim 1, wherein a further step of predicting the remaining run-time is carried out taking into account an overpotential after recharging of the battery.

7. A recharge prediction unit (1) comprising
   a processor,
   a connecting device that is arranged to establish a connection between the recharge prediction unit and a battery,
   an updating device that is arranged for updating at least one battery parameter for a prediction of the state of charge of the battery, and
   a memory for storing the at least one battery parameter for the prediction of the state of charge of the battery, wherein
the up-dating device is arranged for up-dating the at least one parameter when the connecting device is connected to the battery during charging of the battery, and
wherein the processor is arranged for predicting of the state of charge of the battery during a discharging of the battery while the recharge prediction unit is disconnected from the battery, using the battery parameters measured during charging of the battery, and wherein the predicting is without carrying out any measurements during the discharging of the battery.

8. Recharge prediction unit (1) according to claim 7, enabling a prediction of the state of charge of a battery (102) according to the method of claim 1.

9. Battery charger (103) comprising a recharge prediction unit (1) according to claim 7.

10. Implantable device (100) comprising a recharge prediction unit (1) according to claim 7.

11. Battery (102) comprising a recharge prediction unit (1) according to claim 7.

12. System having a recharge prediction unit (1) according to claim 7, and a battery (102) arranged to power an electrical load (100), wherein the recharge prediction unit is disconnected from the battery during discharging of the battery.

13. System according to claim 12, wherein the electrical load is a medical device (100).


**Patentansprüche**

1. Verfahren zum Bestimmen des Ladezustands einer Batterie (102), umfassend die Schritte:

Anschließen (11) einer Wiederaufladevorhersageeinheit an die Batterie vor dem Laden der Batterie,
Laden (16, 204) der Batterie,
Messen (14, 18) von Batterieparametern während des Ladens der Batterie,
Trennen (21) der Wiederaufladevorhersageeinheit von der Batterie vor dem Entladen der Batterie,
Entladen der Batterie,
Vorhersagen (15) des Ladezustands der Batterie unter Verwendung der Wiederaufladevorhersageeinheit und unter Verwendung der Batterieparameter, welche während des Ladens (16, 204) der Batterie gemessen wurden, wobei die Vorhersage ohne Durchführen jedweder Messungen während des Entladens der Batterie erfolgt,
wobei die Wiederaufladevorhersageeinheit während des Entladens der Batterie von der Batterie getrennt ist.

2. Verfahren nach Anspruch 1, wobei der Schritt des Vorhersagens (15) des Ladezustands der Batterie unter Verwendung eines Parameters ausgeführt wird, welcher eine Zeitspanne angibt, welche seit dem Abschluss des Wiederaufladens der Batterie abgelaufen ist.

3. Verfahren nach Anspruch 1, wobei der Schritt des Vorhersagens (15) des Ladezustands der Batterie unter Verwendung eines Parameters ausgeführt wird, welcher ein Merkmal der Batterie angibt.

4. Verfahren nach Anspruch 1, wobei der Schritt des Vorhersagens (15) des Ladezustands der Batterie unter Verwendung eines Parameters ausgeführt wird, welcher einen Umgebungsparameter der Batterie angibt.

5. Verfahren nach Anspruch 1, wobei der Schritt des Vorhersagens (15) des Ladezustands der Batterie mittels Abbildens der Alterung der Batterie ausgeführt wird.

6. Verfahren nach Anspruch 1, wobei ein weiterer Schritt des Vorhersagens der verbleibenden Laufzeit unter Berücksichtigung einer Überspannung nach dem Wiederaufladen der Batterie ausgeführt wird.

7. Wiederaufladevorhersageeinheit (1), umfassend einen Prozessor,
eine Anschlussvorrichtung, welche eingerichtet ist, um eine Verbindung zwischen der Wiederaufladevorhersageeinheit und einer Batterie herzustellen,
eine Aktualisierungsvorrichtung, welche zum Aktualisieren zumindest eines Batterieparameters zum Vorhersagen des Ladezustands der Batterie eingerichtet ist; und
einen Speicher zum Speichern des zumindest einen Batterieparameters zum Vorhersagen des Ladezustands der Batterie; wobei
die Aktualisierungsvorrichtung für das Aktualisieren des zumindest einen Parameters eingerichtet ist, wenn die Anschlussvorrichtung während des Ladens der Batterie mit der Batterie verbunden ist, und wobei der Prozessor zum Vorhersagen des Ladezustands der Batterie während eines Entladens der Batterie eingerichtet ist, während die Wiederaufladevorhersageeinheit von der Batterie getrennt ist, unter Verwendung der Batterieparameter, welche während des Ladens der Batterie gemessen wurden, und wobei das Vorhersagen ohne Durchführen jedweder Messungen während des Entladens der Batterie erfolgt.

**8.** Wiederaufladevorhersageeinheit (1) nach Anspruch 7, welche eine Vorhersage des Ladezustands einer Batterie (102) nach dem Verfahren nach Anspruch 1 ermöglicht.

**9.** Batterieladegerät (103), umfassend eine Wiederaufladevorhersageeinheit (1) nach Anspruch 7.

**10.** Implantierbare Vorrichtung (100), umfassend eine Wiederaufladevorhersageeinheit (1) nach Anspruch 7.

**11.** Batterie (102), umfassend eine Wiederaufladevorhersageeinheit (1) nach Anspruch 7.

**12.** System mit einer Wiederaufladevorhersageeinheit (1) nach Anspruch 7 und eine Batterie (102), welches eingerichtet ist, eine elektrische Last (100) zu versorgen, wobei die Wiederaufladevorhersageeinheit während des Entladens der Batterie von der Batterie getrennt ist.

**13.** System nach Anspruch 12, wobei die elektrische Last eine medizinische Vorrichtung (100) ist.

**Revendications**

**1.** Procédé de détermination de l'état de chargement d'une batterie (102), comprenant les étapes consistant à :

connecter (11) une unité de prédiction de rechargement à la batterie avant de charger la batterie,
charger (16, 204) la batterie,
mesurer (14, 18) les paramètres de la batterie au cours du chargement de la batterie,
déconnecter (21) l'unité de prédiction de rechargement de la batterie avant de décharger la batterie,
décharger la batterie,
prédire (15) l'état de chargement de la batterie en utilisant l'unité de prédiction de rechargement et en utilisant les paramètres de la batterie mesurés au cours du chargement (16, 204) de la batterie, la prédiction se faisant sans réaliser de mesures quelconques au cours du déchargement de la batterie,
dans lequel l'unité de prédiction de rechargement est déconnectée de la batterie au cours du déchargement de la batterie.

**2.** Procédé selon la revendication 1, dans lequel l'étape de prédiction (15) de l'état de chargement de la batterie est effectuée en utilisant un paramètre indiquant une période de temps qui s'est écoulée depuis que le rechargement de la batterie s'est terminé.

**3.** Procédé selon la revendication 1, dans lequel l'étape de prédiction (15) de l'état de chargement de la batterie est effectuée en utilisant un paramètre indiquant une caractéristique de la batterie.

**4.** Procédé selon la revendication 1, dans lequel l'étape de prédiction (15) de l'état de chargement de la batterie est effectuée en utilisant un paramètre indiquant un paramètre environnemental de la batterie.

**5.** Procédé selon la revendication 1, dans lequel l'étape de prédiction (15) de l'état de chargement de la batterie est effectuée par modélisation du vieillissement de la batterie.

**6.** Procédé selon la revendication 1, dans lequel une autre étape de prédiction du temps de fonctionnement restant est effectuée en tenant compte d'un surpotentiel après rechargement de la batterie.

**7.** Unité de prédiction de rechargement (1) comprenant un processeur,
un dispositif de connexion qui est agencé pour établir une connexion entre l'unité de prédiction de rechargement et une batterie,
un dispositif de mise à jour qui est agencé pour mettre à jour au moins un paramètre de batterie pour une prédiction de l'état de chargement de la batterie; et
une mémoire pour stocker le au moins un paramètre de batterie pour la prédiction de l'état de chargement de la batterie, dans laquelle
le dispositif de mise à jour est agencé pour mettre à jour le au moins un paramètre lorsque le dispositif de connexion est connecté à la batterie au cours du chargement de la batterie, et
dans lequel le processeur est agencé pour prédire l'état de chargement de la batterie au cours d'un déchargement de la batterie tandis que l'unité de prédiction de rechargement est déconnectée de la batterie en utilisant les paramètres de la batterie mesurés au cours du chargement de la batterie et dans lequel la prédiction se fait sans effectuer de mesures quelconques au cours du déchargement de la batterie.

**8.** Unité de prédiction de rechargement (1) selon la revendication 7, permettant une prédiction de l'état de chargement d'une batterie (102) selon le procédé de la revendication 1.

**9.** Chargeur de batterie (103) comprenant une unité de prédiction de rechargement (1) selon la revendication 7.

**10.** Dispositif implantable (100) comprenant une unité de prédiction de rechargement (1) selon la revendication 7.

**11.** Batterie (102) comprenant une unité de prédiction de rechargement (1) selon la revendication 7.

**12.** Système ayant une unité de prédiction de rechargement (1) selon la revendication 7 et une batterie (102) agencée pour alimenter une charge électrique (100), dans lequel l'unité de prédiction de rechargement est déconnectée de la batterie au cours du déchargement de la batterie.

**13.** Système selon la revendication 12, dans lequel la charge électrique est un dispositif médical (100).

FIG. 1

FIG. 2

FIG. 3

FIG. 4

104″

103″

R!

120

102″

# FIG. 5

FIG. 6

FIG. 7

**EP 2 162 752 B1**

**Patent documents cited in the description**

- US 6901293 B2
- US 5717256 A
- WO 0069012 A